# EUROPÄISCHE PATENTSCHRIFT

(11) **EP 3 595 819 B1**
(45) Veröffentlichungstag und Bekanntmachung des Hinweises auf die Patenterteilung: **06.12.2023**
(21) Anmeldenummer: 18711526.6
(22) Anmeldetag: 13.03.2018
(51) Int. Cl.: B06B 1/02, H04R 1/02, G10K 9/125, G10K 11/24, H04R 17/00

(54) **AM KÖRPER TRAGBARES ELEMENT UND VERWENDUNG DES AM KÖRPER TRAGBAREN ELEMENTS**
PART THAT CAN BE WORN ON THE BODY, AND USE OF SAID PART
ÉLÉMENT PORTABLE SUR LE CORPS ET UTILISATION DE L'ÉLÉMENT PORTABLE SUR LE CORPS

(30) Priorität: 15.03.2017 DE 102017105529
(43) Veröffentlichungstag der Anmeldung: 22.01.2020
(73) Patentinhaber: TDK Electronics AG, 81671 München (DE)
(72) Erfinder: RAUCH, Wolfgang, 8530 Deutschlandsberg (AT)
(74) Vertreter: Epping - Hermann - Fischer
(86) Internationale Anmeldenummer: PCT/EP2018/056224
(87) Internationale Veröffentlichungsnummer: WO 2018/167053

(56) Entgegenhaltungen:
- WO-A2-02/062096
- WO-A2-2016/046810
- DE-U1-202005 004 255
- US-A1- 2009 245 553
- US-A1- 2010 141 407

## Beschreibung

Die vorliegende Erfindung betrifft ein am Körper tragbares Element, das es ermöglicht, ein akustisches Signal haptisch wahrzunehmen.

Für ein solches Element sind verschiedenste Anwendungsmöglichkeiten denkbar. Das Element kann dazu eingesetzt werden, um gehörlosen sowie gehörschwachen Personen das Wahrnehmen von Melodien zu ermöglichen. Ferner könnte das Element unterstützend bei einer Therapie zum Wiedererlernen des Hörens eingesetzt werden. Auch im Bereich von Virtual Reality Anwendungen könnte das Element eingesetzt werden, um durch das Erzeugen von haptischen Eindrücken eine virtuelle Realität für einen Träger des Elements haptisch wahrnehmbar zu gestalten.

Das Dokument US 2009/245553 A1 beschreibt eine Vorrichtung zur Knochenleitung, welche teilweise hinter dem äußeren Ohr positioniert wird. Die Vorrichtung weist einen Signalwandler auf, der ein piezoelektrisches Element aufweisen kann. Das piezoelektrische Element verformt sich als Reaktion auf ein elektrisches Signal und erzeugt dabei Vibrationen, welche zum Schädelknochen weitergeleitet werden, um eine Knochenleitung zu erzeugen.

Das Dokument WO 2016/046810 A2 beschreibt eine auf der Haut tragbare Signalwandlervorrichtung. Die Vorrichtung weist einen ersten Signalwandler auf, welcher dazu ausgelegt ist in einem ersten Frequenzbereich zu vibrieren, um ein hörbares Signal zu erzeugen. Der Signalwandler kann ein piezoelektrisches Element aufweisen.

Das Dokument DE 20 2005 004255 U1 beschreibt ein Bekleidungsstück mit mehreren über seine Fläche verteilten Vibrationselementen. Die Vibrationselemente sind sogenannte Mikrovibratoren von geringen Ausmaßen, die sich auf das Baumwollgewebe aufkleben oder in sonstiger Weise mit dem Baumwollgewebe anbringen lassen.

Das Dokument WO 02/062096 A2 beschreibt eine Anordnung zur elektroakustischen Umwandlung von Audiosignalen, insbesondere Sprachsignalen, mit einem flexiblen Element, das eine mechanische Druckänderung in eine elektrische Spannungsänderung (Mikrofon) oder eine elektrische Spannungsänderung in eine mechanisch Druckänderung (Lautsprecher) umsetzt und mit dem Gewebe von Kleidungsstücken verbunden. Statt das flexible Element (Schallwandler) mit dem Kleidungsgewebe zu verbinden ist es auch möglich, Gewebefasern bereits mit den Bestandteilen des flexiblen Elements zu versehen.

Aufgabe der vorliegenden Erfindung ist es nunmehr, ein am Körper tragbares Element anzugeben, das es ermöglicht, ein akustisches Signal haptisch wahrzunehmen. Dabei sollte das am Körper tragbares Element vorzugsweise derart ausgestaltet sein, dass es schnelle Änderungen in den Frequenzen des akustischen Signals mit einer möglichst kurzen Reaktionszeit wiedergeben kann.

Diese Aufgabe wird durch ein am Körper tragbares Element gemäß dem vorliegenden Anspruch 1 gelöst.

Es wird ein am Körper tragbares Element vorgeschlagen, das zumindest ein piezoelektrisches Element aufweist, das dazu ausgestaltet ist, zu vibrieren und auf diese Weise einen haptischen Eindruck eines akustischen Signals zu erzeugen.

Piezoelektrische Elemente zeichnen sich durch eine schnelle Reaktionszeit aus und sind dementsprechend dazu geeignet, eine schnelle Folge von Tönen mit sich ändernder Frequenz als haptisches Signal wiederzugeben. Dabei können die piezoelektrischen Elemente auch dazu geeignet sein, Melodien als haptischen Eindruck wiederzugeben. Mechanische Elemente, die ebenfalls in Vibration versetzt werden können, beispielsweise vibrierende Feinmotoren oder eine Membran, die mechanisch oder auch elektrisch in Schwingungen versetzt werden könnten, weisen üblicherweise eine Einschwingzeit auf, bevor sie ihre gewünschte Schwingungsamplitude erreichen können. Im Gegensatz dazu zeichnet sich das piezoelektrische Element durch eine extrem kurze Reaktionszeit aus.

Das piezoelektrische Element kann dazu geeignet sein, sowohl den Rhythmus als auch die Melodie des akustischen Signals haptisch wahrnehmbar zu machen. Unter dem Rhythmus wird hierbei die zeitliche Abfolge der Töne des akustischen Signals verstanden. Die Melodie ergibt sich aus den unterschiedlichen Tonhöhen der Töne des akustischen Signals. Das piezoelektrische Element kann dazu ausgestaltet sein, unterschiedliche Tonhöhen beziehungsweise Frequenzen des akustischen Signals haptisch durch unterschiedliche Vibrationsfrequenzen des piezoelektrischen Elementes wiederzugeben. Der Rhythmus kann durch Abstände beziehungsweise Pausen zwischen den Vibrationen des piezoelektrischen Elementes wiedergegeben werden. Ferner kann auch eine Dynamik des akustischen Signals über die Schwingungsamplitude des piezoelektrischen Elementes haptisch wiedergegeben werden.

Als am Körper tragbares Element können hierbei alle Materialien angesehen werden, die dazu geeignet sind, als künstliche Hülle einen Körper eines Menschen mehr oder weniger eng anliegend zu umgeben. Beispielsweise ist hier auch ein Brustgurt als am Körper tragbares Element anzusehen.

Das am Körper tragbare Element kann dazu angeordnet und ausgestaltet sein, ein Signal an das piezoelektrische Element anzulegen, das aus dem akustischen Signal bestimmt wurde, indem die Frequenzen des akustischen Signals mit einem Skalierungsfaktor multipliziert werden und das akustische Signal dadurch in ein haptisch wahrnehmbares Signal umgewandelt wird.

Als ein nicht erfindungsgemäßes Beispiel kann das am Körper tragbare Element dazu angeordnet und ausgestaltet sein, ein Äquivalent-Signal an das piezoelektrische Element anzulegen, das aus dem akustischen Signal bestimmt wurde, indem aus dem akustischen Signal mittels einer Übertragungsfunktion das Äquivalent-Signal bestimmt wird, wobei die Form und die Intensität des Äquivalent-Signals mit dem akustischen Signal korreliert, und das Äquivalent-Signal ein haptisch wahrnehmbares Signal ist. Bei der Übertragungsfunktion kann es sich um eine nahezu beliebige Funktion handeln, die das akustische Signal in ein Äquivalent-Signal transferiert, dessen Form und Intensität mit dem akustischen Signal korreliert.

Das am Körper tragbare Element kann eine Elektronik aufweisen, die dazu ausgestaltet ist, die Frequenzen des akustischen Signals mit einem Skalierfaktor zu multiplizieren und das akustische Signal dadurch in ein haptisch wahrnehmbares Signal umzuwandeln. Der Skalierfaktor ist dabei kleiner als 1, da die haptisch wahrnehmbaren Frequenzen geringer sind als die Frequenzen des akustisch wahrnehmbaren Frequenzspektrums.

Durch die Multiplikation des akustischen Signals mit einem festen Skalierfaktor kann das akustische Signal in ein haptisch wahrnehmbares Signal derart gewandelt werden, dass Unterschiede zwischen hohen Tönen und tiefen Tönen weiterhin bestehen bleiben. Beispielsweise kann einem ersten Ton des akustischen Signals, der höher ist als ein zweiter Ton des akustischen Signals, ein erster Ton des haptisch wahrnehmbaren Signals entsprechen, der ebenfalls höher ist als ein zweiter Ton des haptisch wahrnehmbaren Signals, der wiederum dem zweiten Ton des akustischen Signals entspricht.

Die Elektronik kann dazu ausgestaltet sein, eine Wechselspannung mit der Frequenz des haptisch wahrnehmbaren Signals an das zumindest eine piezoelektrische Element anzulegen. Dementsprechend kann das piezoelektrische Element zu einer Schwingung mit der jeweiligen Frequenz angeregt werden. Insbesondere kann die Elektronik dazu ausgestaltet sein, Wechselspannungen mit verschiedenen Frequenzen an das piezoelektrische Element anzulegen.

Die die Elektronik kann in das am Körper tragbare Element integriert sein. Alternativ kann das am Körper tragbare Element mit einem externen Gerät verbindbar sein, in das die Elektronik integriert ist. Das externe Gerät kann beispielsweise ein Mobiltelefon, eine Uhr oder eine externe Ansteuerung sein.

Die Elektronik kann dazu im Stande sein, im Rahmen einer Signalverarbeitung aus dem akustischen Signal das haptisch wahrnehmbare Signal zu generieren.

Das akustische Signal kann ein aufgezeichnetes Audiosignal sein. Das am Körper tragbare Element oder die Elektronik können einen Speicher aufweisen, in dem das aufgezeichnete Audiosignal hinterlegt ist.

Das akustische Signal kann aus einer in Echtzeit übertragenden externen Geräuschquelle stammen. Das am Körper tragbare Element oder die Elektronik können ein Mikrophon aufweisen, das dazu ausgestaltet ist, das akustische Signal der externen Geräuschquelle aufzunehmen.

Das piezoelektrische Element kann dazu ausgestaltet sein, mit unterschiedlich großen Amplituden zu vibrieren und dadurch unterschiedliche Lautstärken des akustischen Signals haptisch wiederzugeben. Eine starke Vibration kann dementsprechend von einem Träger des am Körper tragbaren Elements mit einem lauten Signal assoziiert werden. Eine schwache Vibration kann von einem Träger des am Körper tragbaren Elements mit einem leisen Signal assoziiert werden.

Das zumindest eine piezoelektrische Element kann dazu ausgestaltet sein, mit verschiedenen Frequenzen zu vibrieren. Vorzugsweise ist das piezoelektrische Element derart ausgestaltet, dass die Frequenzen, mit denen das piezoelektrische Element vibriert, um einen haptischen Eindruck zu erzeugen, weit von einer Resonanzfrequenz des piezoelektrischen Elementes entfernt sind. Dementsprechend kann es nicht zu Resonanzeffekten kommen, die die Vibrationsamplitude frequenzabhängig verändern würden. Ist das piezoelektrische Element dazu ausgestaltet, mit verschiedenen Frequenzen zu vibrieren, können unterschiedliche Frequenzen des akustischen Signals für einen Träger des am Körper tragbaren Elements haptisch wiedergegeben werden.

Das am Körper tragbare Element kann einen Speicher aufweist, in dem das akustische Signal hinterlegt ist. In dem Speicher kann ferner das dem akustischen Signal entsprechende haptische Signal hinterlegt sein, sodass dieses nicht erneut berechnet werden muss. In dem Speicher können mehrere akustische Signale und gegebenenfalls die damit verbundenen haptischen Signale hinterlegt sein. In einem Speicher abgespeicherte Signale können beispielsweise im Zuge von Therapien zum Wiedererlernen des Hörens unterstützend eingesetzt werden. Dabei können die haptischen Signale einmalig oder wiederholt einem Nutzer vorgeführt werden.

Alternativ oder ergänzend kann das am Körper tragbare Element ein Mikrophon aufweisen, das dazu ausgestaltet ist, das akustische Signal aufzunehmen. Dementsprechend kann ein akustisches Signal, das aktuell in der unmittelbaren Umgebung des am Körper tragbaren Elements auftritt, für einen Träger des am Körper tragbaren Elements haptisch erfahrbar gemacht werden. Ein solches am Körper tragbares Element ist insbesondere für die haptische Wiedergabe von Musik denkbar. Es könnte beispielsweise während eines Konzertes getragen werden.

Das zumindest eine piezoelektrische Element kann einen Grundkörper und eine Verstärkungseinheit aufweisen. In dem Grundkörper können Innenelektroden und piezoelektrische Schichten in einer Stapelrichtung abwechselnd aufeinander gestapelt sein. Die Verstärkungseinheit kann auf einer Oberseite des Grundkörpers angeordnet sein. Die Verstärkungseinheit kann dazu ausgestaltet sein, eine Längenänderung des Grundkörpers in eine Richtung senkrecht zur Stapelrichtung in eine Längenänderung der Verstärkungseinheit in Stapelrichtung zu transformieren. Insbesondere kann die Verstärkungseinheit dazu ausgestaltet sein, eine Vibration des Grundkörpers zu verstärken und dabei insbesondere die Amplitude der Vibration zu vergrößern. Die Verstärkungseinheit kann derart an dem Grundkörper befestigt sein, dass sie eine Schwingungsamplitude des Grundkörpers verstärkt. Dazu kann die Verstärkungseinheit beispielsweise ein kegelstumpfförmiges Blech aufweisen. Das Blech kann beispielsweise aus Titan bestehen. Bei der Verstärkungseinheit kann es sich um ein rein mechanisches Element handeln. Dementsprechend kann die Verstärkungseinheit auch als mechanische Verstärkungseinheit bezeichnet werden.

Das am Körper tragbare Elementkann mehrere piezoelektrische Elemente aufweisen, die jeweils dazu ausgestaltet sind, zu vibrieren und auf diese Weise einen haptischen Eindruck eines akustischen Signals zu erzeugen. Jedes dieser piezoelektrischen Elemente kann dabei von der Elektronik angesteuert werden. Jedes dieser piezoelektrischen Elemente kann dazu ausgestaltet sein, mit unterschiedlichen Frequenzen, in unterschiedlichen zeitlichen Abständen und mit unterschiedlichen Amplituden vibrieren, um auf diese Weise unterschiedliche Tonfrequenzen, Rhythmen und Lautstärken wiederzugeben.

Bei dem am Körper tragbaren Element kann es sich beispielsweise um ein Kleidungsstück oder ein Accessoire handeln. Bei dem Kleidungsstück kann es sich um ein Shirt, einen Socken, eine Anzug für eine VR-Anwendung, einen Taucheranzug, einen Fluganzug oder einen Sportanzug, handeln. Bei dem Accessoire kann es sich beispielsweise um einen Ring, eine Uhr, ein Schmuckstück, ein Heilbehelf, einen Gürtel, einen Kopfhörer, eine Brille, ein aufklebbares Element, wie beispielsweise ein Pflaster oder eine Elektrode eines medizinischen Gerätes, einen Handschuh, einen Brustgurt, oder eine Manschette, handeln. Vorzugsweise wird das piezoelektrische Element an einer Position an dem am Körper tragbaren Element angeordnet, an der es an einer haptisch besonders empfindlichen Stelle des Trägers liegt. Beispielsweise sind die Fingerkuppen besonders sensitiv für haptische Signale. Der Solarplexus ist besonders sensitiv für Signale mit tiefen Frequenzen.

Das piezoelektrische Element kann ein keramischer Aktor, ein Aktor aufweisend ein piezoaktives Polymermaterial oder ein Aktor aufweisend ein piezoresistives Polymermaterial ist. Das piezoelektrische Element kann ein piezoelektrisch aktives Material aufweisen, das in das am Körper tragbare Element eingewebt ist.

Gemäß einem weiteren Aspekt betrifft die vorliegende Erfindung die Verwendung des am Körper tragbaren Elements, um Musik haptisch wahrnehmbar zu machen.

Im Folgenden wird die vorliegende Erfindung anhand der Figuren weiter beschrieben.
Figur 1 zeigt ein piezoelektrisches Element im Querschnitt.
Figur 2 zeigt ein erstes Ausführungsbeispiel eines Kleidungsstückes.
Figur 3 zeigt ein zweites Ausführungsbeispiel eines Kleidungsstückes.
Figur 4 zeigt ein drittes Ausführungsbeispiel eines Kleidungsstückes.

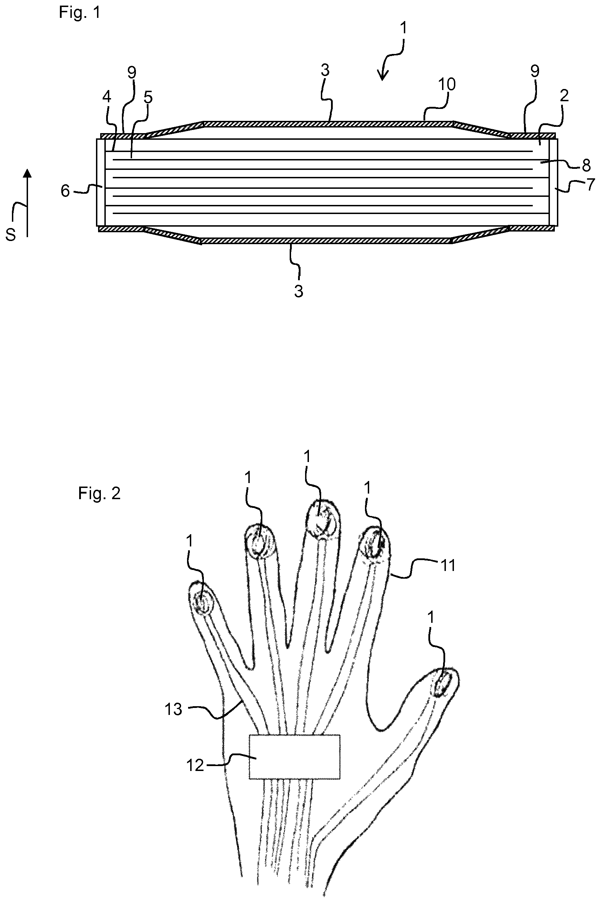

Figur 1 zeigt ein piezoelektrisches Element 1, das in einem am Körper tragbaren Element verwendet werden kann, um einen haptischen Eindruck zu erzeugen, in einem Querschnitt.

Das piezoelektrische Element 1 weist einen Grundkörper 2 und eine mechanische Verstärkungseinheit 3 auf. Der Grundkörper 2 weist in einer Stapelrichtung S abwechselnd übereinander gestapelte erste Innenelektroden 4 und zweite Innenelektroden 5 auf. Die Innenelektroden 4, 5 können aus Kupfer bestehen. Ferner weist der Grundkörper 2 eine erste Außenelektrode 6, die mit den ersten Innenelektroden 4 elektrisch verbunden ist, auf. Der Grundkörper 2 weist ferner eine zweite Außenelektrode 7 auf, wobei die zweiten Innenelektroden 5 mit der zweiten Außenelektrode 7 elektrisch kontaktiert sind. Die erste Außenelektrode 6 und die zweite Außenelektrode 7 sind auf einander gegenüberliegenden Seitenflächen des Grundkörpers angeordnet, wobei die Flächennormalen der Seitenflächen jeweils senkrecht zur Stapelrichtung S stehen.

Ferner weist der Grundkörper piezoelektrische Schichten 8 auf, wobei zwischen zwei Innenelektroden 4, 5 jeweils eine piezoelektrische Schicht 8 angeordnet ist. Die piezoelektrischen Schichten 8 können aus einer Blei-Zirkonat-Titanat-Keramik (PZT-Keramik) bestehen. Die piezoelektrischen Schichten 8 sind in Stapelrichtung S polarisiert. Der Grundkörper 2 ist dazu ausgestaltet, infolge einer zwischen den Innenelektroden 4, 5 angelegten Spannung eine Längenänderung in eine Richtung senkrecht zur Stapelrichtung S zu erfahren. Dabei wird der piezoelektrische d31-Effekt genutzt.

Der Grundkörper 2 hat eine flache, quaderförmige Bauform. Er kann eine quadratische Grundfläche mit den Abmessungen in einem Bereich zwischen 0,2 cm x 0,2 cm und 2,0 cm x 2,0 cm und eine Höhe zwischen 0,2 mm und 1 mm aufweisen. Die Höhe gibt dabei die Ausdehnung des Grundkörpers 2 in der Stapelrichtung S an. Die Flächennormale der Grundfläche weist in die Stapelrichtung S.

Unmittelbar auf einer Oberseite des Grundkörpers 2 ist die mechanische Verstärkungseinheit 3 angeordnet. Die mechanische Verstärkungseinheit 3 weist ein Blech aus Titan auf. Das Blech hat eine im Wesentlichen kegelstumpfförmige Form. Das Blech ist dazu ausgestaltet, eine Längenänderung des Grundkörpers 2 in eine Richtung senkrecht zur Stapelrichtung S in eine Längenänderung der Verstärkungseinheit 3 in Stapelrichtung S zu transformieren.

Die Verstärkungseinheit 3 weist einen Randbereich 9 auf, der an der Oberseite des Grundkörpers 2 befestigt ist. Die Verstärkungseinheit 3 weist ferner einen mittleren Bereich 10 auf, der sich an den Randbereich 9 anschließt und der sich relativ zu dem Randbereich 9 bewegen kann. Die Verstärkungseinheit ist derart geformt, dass es beim Zusammenziehen oder Auseinanderziehen des Randbereichs 9 zu einer erheblichen Anhebung oder Absenkung des mittleren Bereiches 10 kommt. Dabei kann sich der Abstand des mittleren Bereichs 10 von der Oberseite des Grundkörpers 2 ändern. Erfährt der Grundkörper 2 somit infolge einer zwischen den Innenelektroden 4, 5 angelegten Spannung eine Querkontraktion, wird diese durch die mechanische Verstärkungseinheit 3 in eine Schwingung in Stapelrichtung S mit einer vergrößerten Amplitude umgewandelt.

Eine zweite Verstärkungseinheit 3 ist auf einer Unterseite des Grundkörpers 2 angeordnet, die der Oberseite des Grundkörpers gegenüberliegt. Die zweite Verstärkungseinheit 3 ist genauso aufgebaut wie die oben beschriebene Verstärkungseinheit 3.

In einer alternativen Ausführungsform könnte das piezoelektrische Element 1 ohne die mechanische Verstärkungseinheiten 3 ausgestaltet sein. In diesem Fall würden die mechanischen Schwingungen des piezoelektrischen Elementes 1 nicht durch die Verstärkungseinheiten 3 verstärkt werden, sie könnten dennoch eine Amplitude aufweisen, die ausreicht, um einen haptisch wahrnehmbaren Eindruck zu erzeugen.

Figur 2 zeigt ein erstes Ausführungsbeispiel eines am Körper tragbaren Elements 11, das das in Figur 1 gezeigte piezoelektrische Element 1 aufweist. Bei dem am Körper tragbaren Element 11 handelt es sich um ein Kleidungsstück, insbesondere einen Handschuh. Der Handschuh weist fünf piezoelektrische Elemente 1 auf. Jedes der piezoelektrischen Elemente 1 ist an einer Fingerkuppe des Handschuhs angeordnet. Das am Körper tragbare Element 11 weist ferner eine Elektronik 12 auf, die über eine Verdrahtung 13 mit jedem der piezoelektrischen Elemente 1 verbunden ist.

Die Elektronik 12 ist dazu ausgestaltet, die piezoelektrischen Elemente 1 anzusteuern und insbesondere eine Spannung zwischen den Innenelektroden 4, 5 anzulegen. Dadurch wird eine Vibration der piezoelektrischen Elemente 1 ausgelöst. Diese Vibration kann von einem Träger des am Körper tragbaren Elements 11 als haptischer Eindruck wahrgenommen werden. Durch die Anordnung der fünf piezoelektrischen Elemente 1 an jeweils einer Fingerkuppe, kann an jedem Finger eines Trägers ein unterschiedlicher haptischer Eindruck erzeugt werden.

Das am Körper tragbare Element 11 ist dazu ausgestaltet, einen haptischen Eindruck eines akustischen Signals zu erzeugen. Dabei ist die Elektronik 12 dazu ausgestaltet, die Frequenzen des akustischen Signals mit einem Skalierfaktor zu multiplizieren und das akustische Signal so in ein Frequenzspektrum zu wandeln, das haptisch wahrnehmbar ist. Haptisch wahrnehmbare Frequenzen liegen im Frequenzspektrum unterhalb der akustisch wahrnehmbaren Frequenzen.

Die Elektronik 12 kann dazu ausgestaltet sein, die piezoelektrischen Elemente 1 mit unterschiedlichen Frequenzen und unterschiedlichen Amplituden schwingen zu lassen. Die unterschiedlichen Frequenzen ermöglichen es unterschiedliche Tonhöhen und damit Melodien für einen Träger des am Körper tragbaren Elements 11 haptisch wahrnehmbar zu machen. Die unterschiedlichen Amplituden ermöglichen es unterschiedliche Lautstärken des akustischen Signals haptisch wiederzugeben.

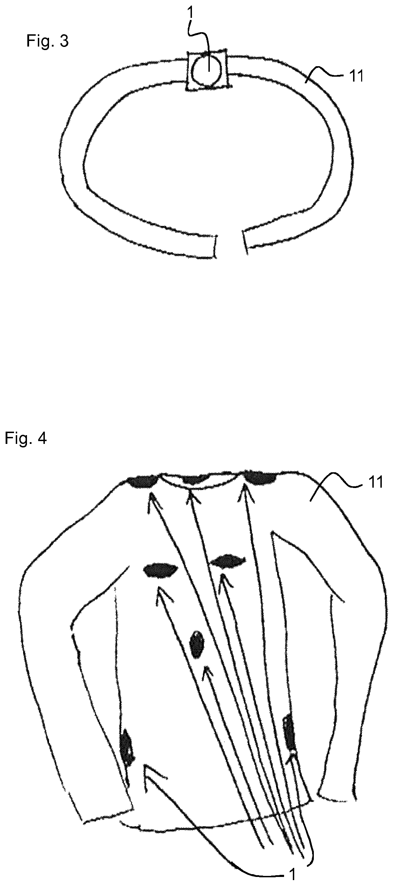

Figur 3 zeigt ein zweites Ausführungsbeispiel eines Kleidungsstücks, das das in Figur 1 gezeigte piezoelektrische Element 1 aufweist. Bei dem Kleidungsstück handelt es sich um einen Brustgurt. Der Brustgurt weist ein einziges piezoelektrisches Element 1 auf. Das piezoelektrische Element 1 ist derart an dem Kleidungsstück angeordnet, dass es auf Höhe des Solarplexus eines Trägers des Kleidungsstückes liegt. Das Kleidungsstück kann besonders gut dazu geeignet sein, tiefe Töne eines Basses haptisch wahrnehmbar zu machen. Solche Töne können insbesondere über den Solarplexus haptisch wahrgenommen werden. Tiefe Frequenzen eines akustischen Signals können zwar auch haptisch ohne ein solches Kleidungsstück wahrgenommen werden, dabei ist allerdings eine gewisse Mindestlautstärke vorausgesetzt, die für dritte Personen als unangenehm empfunden werden könnte. Das Kleidungsstück ermöglicht es nunmehr, das akustische Signal geräuschlos in einen haptischen Eindruck zu wandeln.

Figur 4 zeigt ein drittes Ausführungsbeispiel eines Kleidungsstücks, das ein piezoelektrisches Element 1 aus Figur 1 aufweist. Bei dem Kleidungsstück handelt es sich um ein Shirt. An dem Kleidungsstück sind acht piezoelektrische Elemente 1 an unterschiedlichen Positionen befestigt. Jedes dieser piezoelektrischen Elemente 1 kann von einer Elektronik 12 angesteuert werden.

Das in Figur 1 gezeigte piezoelektrische Element 1 kann in jedes beliebige Kleidungsstück oder jedes beliebige Accessoire eingesetzt werden. Beispielsweise ist auch ein Socken möglich, in dem das in Figur 1 gezeigte piezoelektrische Element 1 eingewoben ist. Dabei könnte dieses insbesondere an einer Fußunterseite eines Trägers des Sockens angeordnet sein, da die Fußunterseite besonders empfindlich auf haptische Eindrücke reagiert.

### Bezugszeichenliste

- 1: piezoelektrisches Element
- 2: Grundkörper
- 3: Verstärkungseinheit
- 4: erste Innenelektrode
- 5: zweite Innenelektrode
- 6: erste Außenelektrode
- 7: zweite Außenelektrode
- 8: piezoelektrische Schicht
- 9: Randbereich
- 10: mittlerer Bereich
- 11: am Körper tragbares Element
- 12: Elektronik
- 13: Verdrahtung

- S: Stapelrichtung

## Patentansprüche

1. Am Körper tragbares Element (11),
das zumindest ein piezoelektrisches Element (1) aufweist, das dazu ausgestaltet ist, zu vibrieren und auf diese Weise einen haptischen Eindruck eines akustischen Signals zu erzeugen,
**dadurch gekennzeichnet, dass**
das am Körper tragbare Element (11) dazu angeordnet und ausgestaltet ist, ein haptisch wahrnehmbares Signal an das piezoelektrische Element (1) anzulegen, das aus dem akustischen Signal bestimmt wurde, indem die Frequenzen des akustischen Signals mit einem Skalierungsfaktor multipliziert werden und das akustische Signal dadurch in das haptisch wahrnehmbare Signal umgewandelt wird, wobei der Skalierungsfaktor kleiner als 1 ist, da die haptisch wahrnehmbaren Frequenzen geringer sind als die Frequenzen des akustisch wahrnehmbaren Frequenzspektrums.

2. Am Körper tragbares Element (11) gemäß Anspruch 1, wobei das piezoelektrische Element (1) ein piezoelektrisch aktives Material aufweist, das in das am Körper tragbare Element eingewebt ist.

3. Am Körper tragbares Element (11) gemäß Anspruch 1 oder 2, wobei eine Elektronik (12) dazu ausgestaltet ist, eine Wechselspannung mit der Frequenz des haptisch wahrnehmbaren Signals an das zumindest eine piezoelektrische Element (1) anzulegen.

4. Am Körper tragbares Element (11) gemäß dem vorherigen Anspruch,
wobei die Elektronik in das am Körper tragbare Element (11) integriert ist,
oder
wobei das am Körper tragbare Element (11) mit einem externen Gerät verbindbar ist, in das die Elektronik integriert ist.

5. Am Körper tragbares Element (11) gemäß dem vorherigen Anspruch,
wobei die Elektronik dazu im Stande ist, im Rahmen einer Signalverarbeitung aus dem akustischen Signal das haptisch wahrnehmbare Signal beziehungsweise das Äquivalent-Signal zu generieren.

6. Am Körper tragbares Element (11) gemäß einem der vorherigen Ansprüche,
wobei das akustische Signal ein aufgezeichnetes Audiosignal ist.

7. Am Körper tragbares Element (11) gemäß Anspruch 7 und einem der Ansprüche 3 bis 5,
wobei das am Körper tragbare Element (11) oder die Elektronik einen Speicher aufweist, in dem das aufgezeichnete Audiosignal hinterlegt ist.

8. Am Körper tragbares Element (11) gemäß einem der Ansprüche 1 bis 5,
wobei das akustische Signal aus einer in Echtzeit übertragenden externen Geräuschquelle stammt.

9. Am Körper tragbares Element (11) gemäß Anspruch 8 und einem der Ansprüche 3 bis 5,
wobei das am Körper tragbare Element (11) oder die Elektronik ein Mikrophon aufweist, das dazu ausgestaltet ist, das akustische Signal der externen Geräuschquelle aufzunehmen.

10. Am Körper tragbares Element (11) gemäß einem der vorherigen Ansprüche,
wobei das piezoelektrische Element (1) dazu ausgestaltet ist, mit unterschiedlich großen Amplituden zu vibrieren und dadurch unterschiedliche Lautstärken des akustischen Signals haptisch wiederzugeben.

11. Am Körper tragbares Element (11) gemäß einem der vorherigen Ansprüche,
wobei das zumindest eine piezoelektrische Element (1) dazu ausgestaltet ist, mit verschiedenen Frequenzen zu vibrieren.

12. Am Körper tragbares Element (11) gemäß einem der vorherigen Ansprüche,
wobei das zumindest eine piezoelektrische Element (1) einen Grundkörper (2), in dem Innenelektroden (4, 5) und piezoelektrische Schichten (8) in einer Stapelrichtung (S) abwechselnd aufeinander gestapelt sind, und eine Verstärkungseinheit (3) aufweist, wobei die Verstärkungseinheit (3) auf einer Oberseite des Grundkörpers (2) angeordnet ist und dazu ausgestaltet ist, eine Längenänderung des Grundkörpers (2) in eine Richtung senkrecht zur Stapelrichtung (S) in eine Längenänderung der Verstärkungseinheit (3) in Stapelrichtung (S) zu transformieren.

13. Am Körper tragbares Element (11) gemäß dem vorherigen Anspruch,
wobei die Verstärkungseinheit (3) ein kegelstumpfförmiges Blech aufweist.

14. Am Körper tragbares Element (11) gemäß einem der vorherigen Ansprüche,
wobei das Kleidungsstück (11) mehrere piezoelektrische Elemente (1) aufweist, die jeweils dazu ausgestaltet sind, zu vibrieren und auf diese Weise einen haptischen Eindruck eines akustischen Signals zu erzeugen.

15. Am Körper tragbares Element (11) gemäß einem der vorherigen Ansprüche,
wobei es sich bei dem am Körper tragbaren Element um ein Kleidungsstück, beispielsweise um ein Shirt, einen Socken, eine Anzug für eine VR-Anwendung, einen Taucheranzug, einen Fluganzug oder einen Sportanzug, handelt,
oder
wobei es sich bei dem am Körper tragbaren Element um ein Accessoire, beispielsweise um einen Ring, eine Uhr, ein Schmuckstück, ein Heilbehelf, einen Gürtel, einen Kopfhörer, eine Brille, ein aufklebbares Element, wie beispielsweise ein Pflaster oder eine Elektrode eines medizinischen Gerätes, einen Handschuh, einen Brustgurt oder eine Manschette, handelt.

16. Am Körper tragbares Element (11) gemäß einem der vorherigen Ansprüche,
wobei das piezoelektrische Element ein keramischer Aktor, ein Aktor aufweisend ein piezoaktives Polymermaterial oder ein Aktor aufweisend ein piezoresistives Polymermaterial ist.

17. Verwendung eines am Körper tragbaren Elements (11) gemäß einem der vorherigen Ansprüche, um Musik haptisch wahrnehmbar zu machen.

## Claims

1. Body-wearable element (11),
comprising at least one piezoelectric element (1) that is designed to vibrate and to thereby produce a haptic impression for an audible signal,
**characterized in that**
the body-wearable element (11) is arranged and designed to apply to the piezoelectric element (1) a haptically perceptible signal that has been determined from the audible signal by multiplying the frequencies of the audible signal by a scaling factor and thereby converting the audible signal into the haptically perceptible signal, the scaling factor being less than 1 because the haptically perceptible frequencies are lower than the frequencies of the audibly perceptible frequency spectrum.

2. Body-wearable element (11) according to claim 1, wherein the piezoelectric element (1) comprises a piezoelectrically active material woven into the body-wearable element.

3. Body-wearable element (11) according to claim 1 or 2, wherein electronics (12) are designed to apply an AC voltage at the frequency of the haptically perceptible signal to the at least one piezoelectric element (1).

4. Body-wearable element (11) according to the preceding claim,
wherein the electronics are integrated in the body-wearable element (11),
or
wherein the body-wearable element (11) is connectable to an external device in which the electronics are integrated.

5. Body-wearable element (11) according to the preceding claim,
wherein the electronics are capable of generating the haptically perceptible signal or the equivalent signal from the audible signal as part of a signal processing.

6. Body-wearable element (11) according to one of the preceding claims,
wherein the audible signal is a recorded audio signal.

7. Body-wearable element (11) according to claim 7 and one of claims 3 to 5,
wherein the body-wearable element (11) or the electronics have a memory that stores the recorded audio signal.

8. Body-wearable element (11) according to any one of claims 1 to 5,
wherein the audible signal comes from an external sound source transmitting in real time.

9. Body-wearable element (11) according to claim 8 and one of claims 3 to 5,
wherein the body-wearable element (11) or the electronics has/have a microphone that is designed to record the audible signal of the external sound source.

10. Body-wearable element (11) according to any one of the preceding claims,
wherein the piezoelectric element (1) is designed to vibrate with amplitudes of different magnitude and to thereby haptically reproduce different volumes of the audible signal.

11. Body-wearable element (11) according to any one of the preceding claims,
wherein the at least one piezoelectric element (1) is designed to vibrate at different frequencies.

12. Body-wearable element (11) according to any one of the preceding claims,
wherein the at least one piezoelectric element (1) comprises a base body (2), in which internal electrodes (4, 5) and piezoelectric layers (8) are alternately stacked on one another in a stacking direction (S), and an amplification unit (3), the amplification unit (3) being arranged on a top of the base body (2) and being designed to transform a longitudinal change in the base body (2) in a direction perpendicular to the stacking direction (S) into a longitudinal change in the amplification unit (3) in the stacking direction (S).

13. Body-wearable element (11) according to the preceding claim,
wherein the amplification unit (3) comprises a frustoconical metal sheet.

14. Body-wearable element (11) according to any one of the preceding claims,
wherein the item of clothing (11) comprises multiple piezoelectric elements (1) that are each designed to vibrate and to thereby produce a haptic impression for an audible signal.

15. Body-wearable element (11) according to any one of the preceding claims,
wherein the body-wearable element is an item of clothing, for example a shirt, a sock, a suit for a VR application, a diving suit, a flight suit or a tracksuit,
or
wherein the body-wearable element is an accessory, for example a ring, a watch, an item of jewellery, a healing aid, a belt, headphones, spectacles, a stick-on element, such as for example a plaster or an electrode of a medical appliance, a glove, a chest strap or a cuff.

16. Body-wearable element (11) according to any one of the preceding claims,
wherein the piezoelectric element is a ceramic actuator, an actuator comprising a piezoactive polymer material or an actuator comprising a piezoresistive polymer material.

17. Use of a body-wearable element (11) according to any one of the preceding claims in order to make music haptically perceptible.

## Revendications

1. Elément portable sur le corps (11), qui présente au moins un élément piézoélectrique (1) qui est configuré pour vibrer et pour générer ainsi une impression haptique d'un signal acoustique,
**caractérisé en ce que** l'élément portable sur le corps (11) est disposé et configuré pour appliquer à l'élément piézoélectrique (1) un signal perceptible de manière haptique qui a été déterminé à partir du signal acoustique **en ce que** les fréquences du signal acoustique sont multipliées par un facteur de mise à l'échelle et le signal acoustique est ainsi converti en signal perceptible de manière haptique,
dans lequel le facteur de mise à l'échelle est inférieur à 1 puisque les fréquences perceptibles de manière haptique sont inférieures aux fréquences du spectre de fréquences perceptibles de manière acoustique.

2. Elément portable sur le corps (11) selon la revendication 1, dans lequel l'élément piézoélectrique (1) présente un matériau piézoélectriquement actif qui est tissé dans l'élément portable sur le corps.

3. Elément portable sur le corps (11) selon la revendication 1 ou 2, dans lequel une électronique (12) est configurée pour appliquer une tension alternative à la fréquence du signal perceptible de manière haptique audit au moins un élément piézoélectrique (1).

4. Elément portable sur le corps (11) selon la revendication précédente,
dans lequel l'électronique est intégrée dans l'élément portable sur le corps (11),
ou
dans lequel l'élément portable sur le corps (11) peut être relié à un appareil externe dans lequel est intégrée l'électronique.

5. Elément portable sur le corps (11) selon la revendication précédente, dans lequel l'électronique est capable dans le cadre d'un traitement de signal de générer le signal perceptible de manière haptique ou le signal équivalent à partir du signal acoustique.

6. Elément portable sur le corps (11) selon l'une quelconque des revendications précédentes, dans lequel le signal acoustique est un signal audio enregistré.

7. Elément portable sur le corps (11) selon la revendication 7 et selon l'une quelconque des revendications 3 à 5, dans lequel l'élément portable sur le corps (11) ou l'électronique présente une mémoire dans laquelle est sauvegardé le signal audio enregistré.

8. Elément portable sur le corps (11) selon l'une quelconque des revendications 1 à 5, dans lequel le signal acoustique provient d'une source sonore externe transmettant en temps réel.

9. Elément portable sur le corps (11) selon la revendication 8 et selon l'une quelconque des revendications 3 à 5, dans lequel l'élément portable sur le corps (11) ou l'électronique présente un microphone qui est configuré pour enregistrer le signal acoustique de la source sonore externe.

10. Elément portable sur le corps (11) selon l'une quelconque des revendications précédentes, dans lequel l'élément piézoélectrique (1) est configuré pour vibrer à des amplitudes de différente grandeur, et pour reproduire ainsi de manière haptique différents volumes du signal acoustique.

11. Elément portable sur le corps (11) selon l'une quelconque des revendications précédentes, dans lequel ledit au moins un élément piézoélectrique (1) est configuré pour vibrer à différentes fréquences.

12. Elément portable sur le corps (11) selon l'une quelconque des revendications précédentes, dans lequel ledit au moins un élément piézoélectrique (1) présente un corps de base (2) dans lequel des électrodes intérieures (4, 5) et des couches piézoélectriques (8) sont empilées en alternance les unes sur les autres dans une direction d'empilement (S), et présente une unité d'amplification (3), dans lequel l'unité d'amplification (3) est disposée sur une face supérieure du corps de base (2) et est configurée pour transformer un changement de longueur du corps de base (2) dans une direction perpendiculaire à la direction d'empilement (S) en un changement de longueur de l'unité d'amplification (3) dans la direction d'empilement (S).

13. Elément portable sur le corps (11) selon la revendication précédente, dans lequel l'unité d'amplification (3) présente une tôle tronconique.

14. Elément portable sur le corps (11) selon l'une quelconque des revendications précédentes, dans lequel le vêtement (11) présente plusieurs éléments piézoélectriques (1) qui sont respectivement configurés pour vibrer et pour générer ainsi une impression haptique d'un signal acoustique.

15. Elément portable sur le corps (11) selon l'une quelconque des revendications précédentes,
dans lequel l'élément portable sur le corps est un vêtement, par exemple un maillot, une chaussette, une combinaison pour une application de RV, une combinaison de plongée, une combinaison de vol ou une combinaison de sport,
ou
dans lequel l'élément portable sur le corps est un accessoire, par exemple une bague, une montre, un bijou, un accessoire médical, une ceinture, un casque, des lunettes, un élément adhésif, comme par exemple un pansement ou une électrode d'un appareil médical, un gant, une ceinture pectorale ou un manchon.

16. Elément portable sur le corps (11) selon l'une quelconque des revendications précédentes, dans lequel l'élément piézoélectrique est un actionneur céramique, un actionneur présentant un matériau polymère piézoactif ou un actionneur présentant un matériau polymère piézorésistif.

17. Utilisation d'un élément portable sur le corps (11) selon l'une quelconque des revendications précédentes pour rendre de la musique perceptible de manière haptique.
